(19) 

**Europäisches Patentamt**

**European Patent Office**

**Office européen des brevets**

(11) **EP 4 585 955 A1**

(12) **EUROPEAN PATENT APPLICATION**

(43) Date of publication:
**16.07.2025 Bulletin 2025/29**

(21) Application number: **24151857.0**

(22) Date of filing: **15.01.2024**

(51) International Patent Classification (IPC):
**G01R 33/56** (2006.01)  **G01R 33/561** (2006.01)

(52) Cooperative Patent Classification (CPC):
**G01R 33/5608;** G01R 33/5611

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventor: **Nickel, Marcel Dominik**
**91074 Herzogenaurach (DE)**

(54) **TRAINING A MACHINE LEARNING MODEL FOR IMAGE ENHANCEMENT FOR USE IN MAGNETIC RESONANCE IMAGE RECONSTRUCTION**

(57) For training a machine learning model, MLM, for image enhancement for use in MR image a point spread function (24) for undersampled MR data acquisition is received. A cropped point spread function (25) is determined, which is given by the point spread function (24) within a predefined spatial region (26). At least one training MR dataset corresponding to at least one coil channel is received and a ground truth reconstructed MR image corresponding to the at least one training MR dataset is received. The MLM is trained in a supervised manner depending on the at least one training MR dataset, on the ground truth reconstructed MR image, and on a Fourier transform of the cropped point spread function (25).

FIG 4

EP 4 585 955 A1

# EP 4 585 955 A1

**Description**

The present invention is directed to a computer implemented training method for training a machine learning model, MLM, for image enhancement for use in magnetic resonance, MR, image reconstruction and to a use of a correspondingly trained MLM for generating a reconstructed MR image of an object based on at least one MR image corresponding to at least one coil channels. The invention also relates to a computer implemented method for MR image reconstruction, wherein an MLM trained by said computer implemented training method is used. The invention is also directed to a corresponding data processing apparatus, to a system for MR imaging comprising such data processing apparatus, and to a corresponding computer program product.

Here and in the following, the term image denotes an image in position space, unless stated otherwise. In MR imaging, image reconstruction denotes the process to generate a two-dimensional image or a three-dimensional image, typically in form of multiple two-dimensional images for multiple positions along the so-called slice direction, in position space from the MR data acquired in k-space depending on MR signals being emitted by an object to be imaged.

In general, the k-space and the position space are related to each other via Fourier transformation. When parallel MR imaging is pursued, MR data are received from multiple receiver coils, which receive the emitted MR signals. Furthermore, k-space subsampling techniques may be employed, where the k-space is sampled with a sampling rate that is too low to fulfil the Nyquist criterion. The latter is also denoted as undersampling or incomplete sampling. The multiple coils or the data provided by them, respectively, are denoted as coil channels. The reconstructed MR image can therefore not be obtained solely by Fourier transforming the acquired k-space data. Rather, more sophisticated reconstruction techniques need to be used. Various methods for MR image reconstruction are known, which may for example involve iterative processes and/or optimizations based on physical relations.

Furthermore, trained machine learning models, MLMs, for example artificial neural networks, ANNs, in particular deep convolutional neural networks, CNNs, may be used for the MR image reconstruction, for example in combination with conventional reconstruction approaches. Such methods are sometimes called deep learning, DL, reconstructions. A review of the topic is presented in the publication G. Zeng et al.: "A review on deep learning MRI reconstruction without fully sampled k-space." BMC Med Imaging 21, 195 (2021).

U-Net, introduced in the publication of O. Ronneberger et al.: "U-Net: Convolutional Networks for Biomedical Image Segmentation" (arXiv:1505.04597v1), is a well-known CNN usable for example for image segmentation or image enhancement.

SENSE based models are described in the publications K.P. Pruessmann et al.: "SENSE: sensitivity encoding for fast MRI.", Magn Reson Med. 1999 Nov, 42(5):952-62 and M. Uecker et al.: " ESPIRiT - an eigenvalue approach to autocalibrating parallel MRI: where SENSE meets GRAPPA.", Magn Reson Med. 2014 Mar, 71(3):990-1001.

One approach to train MLMs, in particular ANNs, is supervised training. Therein, training data, for example training MR datasets in the present context, and corresponding ground truth data, for example a reconstructed MR image in the present context, are provided. The training data is fed to the MLM, which outputs a prediction, which is then compared to the ground truth data by evaluating a loss function. The loss function may be minimized to train the MLM.

MLM based reconstructions involve complex model architectures. Thus, the training process imposes substantial memory requirements to the used hardware. In particular, the used sampling scheme in k-space defines the resulting field of view, FOV, or in other words the size of the reconstructed MR image, in position space. Thus, in principle the used training images have the same size as the images generated after the training is completed during the inference phase. In case of a fully sampled k-space, the used training images could be cropped compared to the nominal image size, neglecting long distance correlations in good approximation. Since incomplete sampling in k-space for a given direction couples all voxels or pixels in this direction within the spatial image domain, however, the training images cannot simply be cropped in the undersampled directions.

It is an objective of the present invention to reduce the required memory for training an MLM for image enhancement for use in MR image reconstruction based on undersampled MR data acquisition.

This objective is achieved by the subject matter of the independent claims. Further implementations and preferred embodiments are subject matter of the dependent claims.

The invention is based on the idea to make it possible to reduce the size of the training images nevertheless by cropping the point spread function in position space and using the Fourier transform of the cropped point spread function for the reconstruction process during the training of the MLM.

According to an aspect of the invention, a computer implemented training method for training a machine learning model, MLM, for image enhancement for use in magnetic resonance, MR, image reconstruction, in particular for parallel MR imaging and/or Compressed Sensing, is provided. Therein a point spread function for an undersampled, in particular irregularly undersampled, MR data acquisition is received. A cropped point spread function is determined, which is given by the point spread function within a predefined spatial region and, in particular, is equal to zero outside of the spatial region. At least one training MR dataset corresponding to at least one coil channel are received and a ground truth reconstructed MR image corresponding to the at least one training MR dataset is received. The MLM is trained in a supervised manner depending on the at least one training MR dataset, on the ground truth reconstructed MR image, and on a Fourier transform of the cropped point spread function.

Unless stated otherwise, all steps of the computer implemented training method may be performed by a data processing apparatus, which comprises at least one computing unit. In particular, the at least one computing unit is configured or adapted to perform the steps of the computer implemented training method. For this purpose, the at least one computing unit may for example store a computer program comprising instructions which, when executed by the at least one computing unit, cause the at least one computing unit to execute the computer implemented training method.

As mentioned above, an undersampled MR data acquisition is an acquisition, whose k-space sampling scheme does not fulfil the Nyquist criterion. The k-space sampling scheme may for example be defined by a discrete function p(k), wherein k denotes coordinates, for example three-dimensional or two-dimensional coordinates, in k-space and p(k) is non-zero, for example equal to one, only at coordinates in k-space, which shall be sampled or, in other words, measured, and equal to zero otherwise.

An irregular undersampling scheme, also denoted as incoherent undersampling scheme, may for example be understood as an undersampling scheme, where the sampled k-space positions are not defined in a regular manner. Regular undersampling is for example achieved by sampling only every R-th row of k-space positions along a certain sampling direction, wherein R > 1 is denoted as acceleration factor or reduction factor.

The point spread function P(x) is given by the Fourier transform of the k-space sampling scheme and vice versa, for example

$$p(k) = FT\big(P(x)\big) = \sum_x f_{k,x}\, P(x),$$

with FT(.) denoting the Fourier transform and with the Fourier coefficients $f_{k,x}$. The k-space sampling scheme may be predefined according to the desired application or use case. The point spread function is then received by Fourier transforming the k-space sampling scheme. Here and in the following, a Fourier transform may be understood as a one-dimensional, two-dimensional, or three-dimensional discrete Fourier transform, unless stated otherwise.

Each training MR dataset of the at least one training MR dataset corresponds to exactly one coil channel of the at least one coil channel. In case of parallel imaging, the at least one training MR dataset comprises at least two training MR datasets corresponding to at least two coil channels and so forth.

The at least one training MR datasets are datasets in k-space obtained, in particular, by means of full k-space sampling. Its respective Fourier transform is a corresponding training MR image.

According to the invention, the sampling pattern is effectively modified by cropping its Fourier transform, the point spread function, in position space and transforming the cropped point spread function back into k-space. It is therefore exploited that the point spread function for an irregular undersampling scheme is strongly localized, in particular around zero. The spatial region may be chosen based on experiments such that the part of the point spread function, which is cropped off, can be neglected compared to the center peak of the point spread function. The Fourier transform of the cropped point spread function is then given by

$$\tilde{p}(k) = FT\left(\tilde{P}(x)\right),$$

wherein $\tilde{P}(x)$ denotes the cropped point spread function.

Consequently, the sampling scheme $p(k)$ is replaced by the Fourier transform of the cropped point spread function $\tilde{p}(k)$ during the training phase of the MLM. Thus, the size of the at least one training MR image can also be reduced to the size of the spatial region. For example, full sized coil images according to full k-space sampling may be provided and cropped according to the cropping of the point spread function such that the resulting size of the at least one training MR image corresponds to the size of the spatial region. In this way, it is also possible to generate multiple training MR images from a single full sized coil image, which can be used in multiple training epochs of the supervised training. The ground truth reconstructed MR image is then for example a reconstructed MR image reconstructed from the at least one training MR image, which is a straightforward computation due to the full sampling.

It is noted that the point spread function is, in particular, cropped around the center x=0. This is not necessarily the case for the full-sized coil image, the cropped-out portions can also be arranged at different positions in the full-sized coil image.

The MLM is an MLM for image enhancement. In other words, an input to the MLM is an image, in the present case an image, which is obtained based on the at least one training MR dataset, and an output of the MLM is an image as well, for example a reconstructed MR image or a preliminary or intermediate version of the reconstructed MR image. Therein, the output image is enhanced with respect to the input image. What exactly is the effect of the enhancement depends on the training MR dataset and the ground truth reconstructed MR image. For example, the at least one training MR dataset may be intentionally corrupted or deteriorated using for example blurring filters, adding noise, and so forth. By means of the training, the MLM learns to enhance an input image accordingly.

For example, in case the MLM is an ANN, it may be a U-Net, as described in the publication of O. Ronneberger et al mentioned in the introductory part of the present disclosure, or an ANN based on the U-Net architecture.

In general terms, a trained MLM may mimic cognitive functions that humans associate with other human minds. In particular, by training based on training data the MLM may be able to adapt to new circumstances and to detect and extrapolate patterns. Another term for a trained MLM is "trained function".

In general, parameters of an MLM can be adapted by means of training. In particular, supervised training, semi-supervised training, unsupervised training, reinforcement learning and/or active learning can be used. Furthermore, representation learning, also denoted as feature learning, can be used. In particular, the parameters of the MLMs can be adapted iteratively by several steps of training. In particular, within the training a certain loss function, also denoted as cost function, can be minimized. In particular, within the training of an ANN, the backpropagation algorithm can be used.

In particular, an MLM can comprise an ANN, a support vector machine, a decision tree and/or a Bayesian network, and/or the machine learning model can be based on k-means clustering, Q-learning, genetic algorithms and/or association rules. In particular, an ANN can be or comprise a deep neural network, a convolutional neural network or a convolutional deep neural network. Furthermore, an ANN can be an adversarial network, a deep adversarial network and/or a generative adversarial network.

The cropping of the point spread function as described therefore allows to use smaller sized training MR images, which reduces the memory requirements for the hardware to carry out the training of the MLM and may also reduce the runtime requirements.

According to several implementations, the MLM is an ANN, for example a CNN.

According to several implementations, training the MLM in the supervised manner comprises carrying out at least two iterations including an initial iteration and a final iteration in the following manner. For each iteration of the at least two iterations,

a) a prior MR image for the respective iteration is received and
b) an optimized MR image is generated by optimizing, in particular minimizing, a predefined first loss function, which depends on the at least one training MR dataset, on the prior MR image for the respective iteration and on the Fourier transform of the cropped point spread function.
c) An enhanced MR image for the respective iteration is generated by applying the MLM to the optimized MR image of the respective iteration. Therein,
d) unless the respective iteration corresponds to the initial iteration, the prior MR image of the respective iteration is received as the enhanced MR image of a preceding iteration of the at least two iterations, in particular an iteration directly preceding the current iteration. The prior MR image of the initial iteration is received as a predefined initial image.

When the at least two iterations have been carried out, a predefined second loss function is evaluated, which depends on the enhanced MR image of the final iteration and on the ground truth reconstructed MR image. The MLM is updated depending on a result of the evaluation of the second loss function.

The optimization of the first loss function may be carried out by using known optimization techniques, for example optimizations according to gradient-based techniques or the like. The optimization may, in particular be carried out iteratively itself. In this case, the at least two iterations may be considered as outer iterations, while the optimization may comprise inner iterations.

The input to the MLM, for example the ANN, is the optimized MR image of the respective iteration and its output is the enhanced MR image. However, the evaluation of the second loss function is not carried out for each iteration but only after all of the two or more iterations have been carried out. Thus, also the optimization of the step b) is included in the training process, which leads to an increased training efficiency.

The initial image may for example be a guess for the reconstructed MR image or it may also be an image with constant pixel values everywhere, for example zero. Each iteration provides the enhanced MR image as another preliminary candidate for the reconstructed MR image, thus iteratively achieving an increased quality of the eventual reconstructed MR image as the enhanced MR image of the final iteration.

Evaluating a loss function can be understood as computing a corresponding value of loss function.

The first loss function may, in particular, be a data consistency term and may be denoted as such.

The total number of the at least two iterations is not necessarily very large, it can for example lie in the range of 2 to 20 iterations or 2 to 10 iterations or 3 to 7 iterations. Thus, the training effort is limited.

The MLM may for example be an ANN, in particular a CNN, for example a U-Net or an architecture based on the U-Net. In this case, updating the MLM can be understood as updating network parameters, in particular network weights and/or bias factors, of the ANN. The updating may be done by using known algorithms, such as backpropagation.

The second loss function may also be a known loss function used for training image enhancement ANNs, such as for example a pixel-wise loss function, for example an L1-loss function or an L2-loss function.

The described steps including the at least two iterations, the evaluation of the second loss function, and the update of the MLM are, in particular, understood as a single training run. A plurality of such runs may be carried out consecutively, until a predetermined termination or convergence criterion regarding the second loss function is reached. Each set of at least one training image may be denoted as a training sample. The number of training samples may lie in the order of 10000 or several times 10000. The number of training epochs may for example lie in the order 100-1000. The total number of training runs is for example given by the product of the number of training samples and the number of training epochs.

The first loss function may be constructed in principle analogously as for known data consistency loss functions in the field of MRI reconstructions, however, instead of the sampling scheme, the Fourier transform of the cropped point spread function is used.

In some implementations, the MLM comprises a single MLM module, for example a single ANN, which is applied to the optimized MR image in step c) of each of the at least two iterations.

In alternative implementations, the MLM comprises a specific MLM module, for example ANN, for each of the at least two iterations. In other words, in each iteration, another MLM module is applied in step c). Updating the MLM comprises updating all MLM modules.

Also mixed implementations are possible, wherein the same MLM module is used for some of the at least two iterations but not for all of them.

According to several implementations, applying the MLM involves multiple iterations and wherein for each iteration a data consistency update based on a signal model as well as a regularization based on an ANN is performed.

According to several implementations, the first loss function comprises a sum over the at least one coil channel, wherein each summand of the sum comprises a term, which is given by the training MR dataset of the respective coil channel multiplied with the Fourier transform of the cropped point spread function.

Furthermore, the sum may be a sum over the at least one coil channel and over the respective k-space positions.

According to several implementations, the optimization of the first loss function is carried out under variation of a variable MR image, while the prior MR image is kept constant during the optimization, in particular of a given iteration.

The variable MR image can be understood as the respective optimization variables of the optimization in step b). As a result of the optimization, the optimal variable MR image corresponds to the optimized MR image.

For example, the first loss function may comprise a data term, which is given by

$$\sum_{l,q} \left\| \tilde{p}(q)\, \tilde{d}_l(q) - \tilde{p}(q) \sum_v f'_{q,v}\, \widetilde{C}_l(v)\, \widetilde{M}(v) \right\|^2,$$

wherein l is an index running over the at least one coil channel, q is an index running over the respective k-space positions, v is an index running over the respective spatial positions, $\tilde{p}(q)$ denotes the Fourier transform of the cropped point spread function, $\tilde{d}_l(q)$ denotes the training MR dataset according to the respective coil channel l, $\widetilde{M}(v)$ denotes the variable MR image, $\tilde{C}_l(v)$ denotes a predefined coil sensitivity map for the respective coil channel, and $f'_{q,v}$ denotes the Fourier coefficients

$$\tilde{p}(q) = FT\left(\tilde{P}(v)\right) = \sum_v f'_{q,v}\, \tilde{P}(v).$$

Therein, the tilde denotes that the sizes of the corresponding matrices in position space correspond to the size of the spatial region. In particular, the training MR images, the variable MR image and the coil sensitivity maps have this size. The coil sensitivity maps may in general be determined by methods known in the art, however cropped to the size of the spatial region. In case the at least one MR training image consists of exactly one MR training image, the coil sensitivity map for the corresponding single coil channel is identical to one.

The data term ensures data consistency and is therefore also denoted as data consistency term.

The first loss function may also comprise a regularization term, which depends on the prior MR image and the variable MR image of the respective iteration.

The regularization term may for example be given by a Tikhonov regularization term. The first loss function, in particular, comprises or consists of a sum of the data term and the regularization term.

The regularization term may quantify a deviation between the prior MR image of the respective iteration and the variable MR image. The regularization term may for example depend on the L1-norm of the difference between the prior MR image of the respective iteration and the variable MR image. For example, the regularization term may be given by

$$\frac{1}{\lambda_n} \left\| \widetilde{M}(v) - \widetilde{M}_n(v) \right\|^2 ,$$

wherein n denotes the respective iteration, $\tilde{M}_n(v)$ denotes the prior MR image of the respective iteration, and $\lambda_n$ denotes a regularization weight. The regularization weight may be the same for all of the at least two iterations or it may be different for different iterations. The regularization weights may be predefined fixed parameters or they may be trained together with the parameters of the MLM, for example.

According to several implementations, each training MR image of the at least one training MR image has a size, which corresponds to the size of the spatial region.

The required memory for the training is therefore significantly reduced compared to a training based on training MR images, whose size is given by the size of the original point spread function.

According to several implementations, at least one preliminary training image corresponding to the at least one coil channel are received. The at least one training MR image is generated by cropping the at least one preliminary training image according to the cropped point spread function, such that each training MR image of the at least one training MR image has a size, which corresponds to the size of the spatial region. The at least one training MR dataset is obtained as a Fourier transform of the least one training MR image.

In particular, the respective sizes of the preliminary training images are larger than the size of the spatial region. Each of the at least one preliminary training image may be a respective coil image obtained from full k-space sampling and has a corresponding size.

For example, several MR training images may be obtained from a single preliminary training image by cutting the preliminary training image into patches with the size of the spatial region. These several MR training images may then for example be used for different training epochs for training the MLM. Consequently, also the effort for generating the required MR training images is reduced.

According to several implementations, the ground truth reconstructed MR image is generated by optimizing a third loss function, which depends on the at least one training MR dataset and on a Fourier transform of a full sampling point spread function.

The full sampling point spread function is the Fourier transform of a sampling scheme for full k-space sampling. Consequently, the third loss function may be given by the data term of the first loss function, wherein the Fourier transform of the cropped point spread function is replaced by the Fourier transform of the full sampling point spread function. In particular, in this case one has $\tilde{p}(q) = 1$ and $\tilde{P}(v) = \delta_{0,v}$. It is noted that the size of the full sampling point spread function is equal to the size of the cropped point spread function.

Consequently, the ground truth reconstructed MR image is obtained in a particularly simple way, for example as

$$\widetilde{M}_{GT}(v) = \sum_I \widetilde{C}_I^*(v) \, \widetilde{D}_I(v),$$

wherein

$$\tilde{d}_I(q) = \sum_u g_{q,u} \, \widetilde{D}_I(u),$$

and wherein $\tilde{D}_I(u)$ denotes the respective training MR image for the coil channel I and $g_{q,u}$ denotes the respective Fourier coefficients.

According to a further aspect of the invention, a use of an MLM for generating a reconstructed MR image of an object based on at least one MR image corresponding to at least one coil channel is provided. Therein, the MLM is trained by using a computer implemented training method according to the invention.

According to a further aspect of the invention, a computer implemented method for MR image reconstruction is provided. Therein, an MLM trained by using a computer implemented training method according to the invention is received. At least one MR image according to an undersampled, in particular irregularly undersampled, MR data acquisition, the at least one MR image corresponding to at least one coil channel and representing an imaged object, are received, in particular from an MRI scanner. A reconstructed MR image is generated depending on the at least one MR image using the trained MLM.

It is noted that no cropping of the point spread function or the at least one MR image is necessary generating the reconstructed MR image. Rather the sampling scheme for the undersampled MR data acquisition may be used. The cropping of the point spread function is only required for the training of the MLM.

It is possible that the sampling scheme for the undersampled MR data acquisition to generate the at least one MR image is identical to the sampling scheme considered for training the MLM. This is, however, not necessarily the case. Thus, once the MLM is trained, it can be used for different applications.

The computer implemented method for MR image reconstruction may, in some implementations, comprise training the MLM by using a computer implemented training method according to the invention. In other implementations, the computer implemented method for MR image reconstruction does not include the steps of the computer implemented training method.

According to several implementations, at least two further iterations are carried out. For each further iteration of the at least two further iterations,

a') a prior MR image for the respective further iteration is received, and

b') an optimized MR image is by optimizing a predefined fourth loss function, which depends on the at least one MR image, on the prior MR image and, in particular, on the sampling scheme for the undersampled MR data acquisition. Further,

c') an enhanced MR image is generated by applying the MLM to the optimized MR image. Therein,

d') the prior MR image of the respective further iteration is received as the enhanced MR image of a preceding further iteration of the at least two further iterations, unless the respective further iteration corresponds to an initial further iteration of the at least two further iterations, and the prior MR image of the initial further iteration is received as a predefined further initial image. The reconstructed MR image is determined as the enhanced MR image of a final further iteration of the at least two further iterations.

The fourth loss function may, in particular, be identical to the first loss functions, wherein the cropped terms are replaced by the corresponding non-cropped terms. For example, the fourth loss function may comprise a data term given by

$$\sum_{I,k} \left\| p(k)\, d_I(k) - p(k) \sum_{x} f_{k,x}\, C_I(x)\, M(x) \right\|^2,$$

wherein k is an index running over the respective k-space positions, x is an index running over the respective spatial positions, $p(k)$ denotes the sampling scheme, $d_I(k)$ denotes the Fourier transform of the MR image according to the respective coil channel I, $M(x)$ denotes the respective variable MR image, $C_I(x)$ denotes a predefined coil sensitivity map for the respective coil channel, and $f_{k,x}$ are the Fourier coefficients. It is noted that $M(x)$ and the $C_I(x)$ are not cropped here. In particular, the $\tilde{C}_I(v)$ used for the training of the MLM in respective implementations may be obtained from the $C_I(x)$ by cropping them accordingly.

The fourth loss function may also comprise a regularization term given by

$$\frac{1}{\lambda_m}\, \| M(x) - M_m(x) \|^2,$$

wherein m denotes the respective iteration, $M_m(x)$ denotes the prior MR image of the respective further iteration, and $\lambda_m$ denotes a regularization weight.

According to a further aspect of the invention, a data processing apparatus comprising at least one computing unit is provided. The at least one computing unit is adapted to carry out a computer implemented training method according to the invention and/or a computer implemented method for MR image reconstruction according to the invention.

A computing unit may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, a system for MR imaging is provided. The system comprises a data processing apparatus according to the invention, wherein the at least one computing unit is adapted carry out a computer implemented method for MR image reconstruction according to the invention. The system comprises an MRI scanner. The at least one computing unit is adapted to control the MRI scanner to generate the at least one MR image.

According to a further aspect of the invention, a first computer program comprising first instructions is provided. When the first instructions are executed by a data processing apparatus, the first instructions cause the data processing apparatus to carry out a computer implemented training method according to the invention.

The first instructions may be provided as program code, for example. The program code can for example be provided as binary code or assembler and/or as source code of a programming language, for example C, and/or as program script, for example Python.

According to a further aspect of the invention, a second computer program comprising second instructions is provided. When the second instructions are executed by a data processing apparatus, the second instructions cause the data processing apparatus to carry out a computer implemented method for MR image reconstruction according to the invention.

The second instructions may be provided as program code, for example. The program code can for example be provided as binary code or assembler and/or as source code of a programming language, for example C, and/or as program script, for example Python.

According to a further aspect of the invention, a computer-readable storage medium, in particular a tangible and non-transient computer-readable storage medium, storing a first computer program and/or a second computer program according to the invention is provided.

The first computer program, the second computer program and the computer-readable storage medium are respective computer program products comprising the first instructions and/or the second instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

Above and in the following, the solution according to the invention is described with respect to the claimed systems as well as with respect to the claimed methods. Features, advantages or alternative embodiments herein can be assigned to the other claimed objects and vice versa. In other words, claims and embodiments for the systems can be improved with features described or claimed in the context of the respective methods. In this case, the functional features of the method are implemented by physical units of the system.

Furthermore, above and in the following, the solution according to the invention is described with respect to methods and systems for MR image reconstruction as well as with respect to methods and systems for providing a trained MLM. Features, advantages or alternative embodiments herein can be assigned to the other claimed objects and vice versa. In other words, claims and embodiments for providing a trained MLM can be improved with features described or claimed in the context of MR image reconstruction. In particular, datasets used in the methods and systems can have the same properties and features as the corresponding datasets used in the methods and systems for providing a trained MLM, and the trained MLMs provided by the respective methods and systems can be used in the methods and systems for MR image reconstruction.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1    shows a schematic block diagram of an exemplary implementation of a system for MR imaging according to the invention;

FIG 2    shows a schematic flow diagram of an exemplary implementation of a computer implemented training method according to the invention;

FIG 3    shows a schematic flow diagram of an exemplary implementation of a computer implemented method for MR image reconstruction according to the invention;

FIG 4    shows a schematic flow diagram of a further exemplary implementation of a computer implemented method for MR image reconstruction according to the invention;

FIG 5    shows a schematic representation of a point spread function for use in a further exemplary implementation of a computer implemented method for MR image reconstruction according to the invention;

FIG 6    shows a schematic representation of a cropped point spread function for use in a further exemplary implementation of a computer implemented training method according to the invention;

FIG 7    shows a schematic representation of a convolutional neural network; and

FIG 8    shows a schematic representation of a further convolutional neural network.

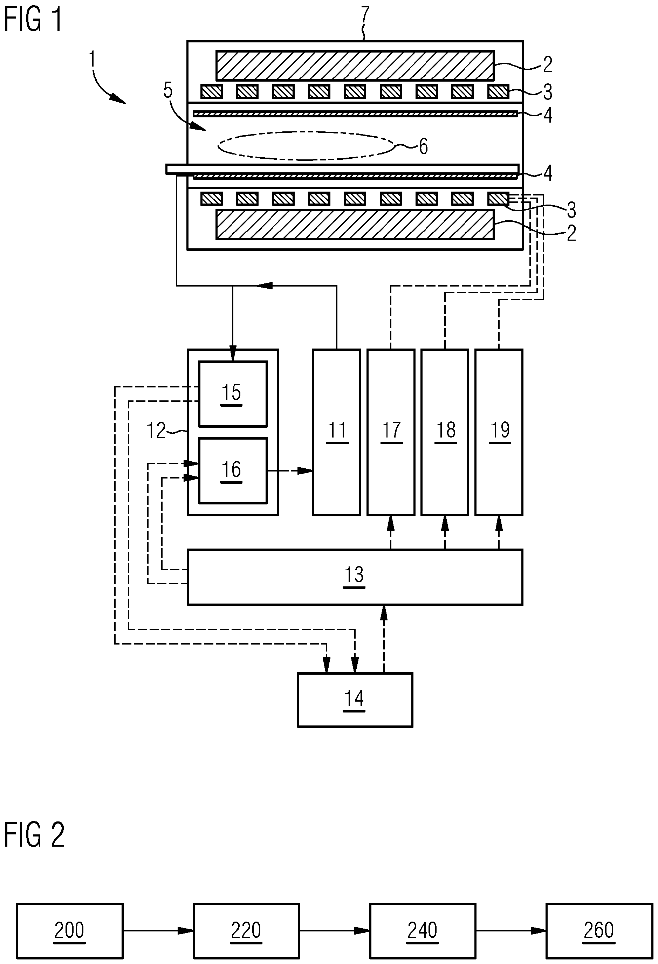

FIG 1 shows schematically an exemplary implementation of a system for MR imaging, also denoted as MRI system, 1 according to the invention. The MRI system 1 comprises a housing 7 defining a bore 5 and a main magnet arrangement 2, which is configured to generate a main magnetic field, also denoted as polarizing magnetic field, within the bore 5. The MRI system 1 comprises an RF system 4, 11, 12, which is configured to apply an asymmetric RF pulse to a target material, in particular a body part of a patient 6, disposed within the bore 5 and to receive MR signals from the target material. For example, the main magnet arrangement 2 may generate a uniform main magnetic field B0 as the main magnetic field and at least one RF coil 4 of the RF system 4, 11, 12 may emit an excitation field B1. The MRI system 1 comprises a data processing apparatus with at least one computing unit 13, 14, which is configured to construct the asymmetric RF pulse by using a computer implemented method for constructing an asymmetric RF pulse according to the present disclosure.

To this end, the at least one computing unit 13, 14 determines a first RF amplitude for a predefined first part of a predefined time interval, and receives an RF amplitude curve, which depends on at least one RF curve parameter. The at least one computing unit 13, 14 determines a combined RF amplitude curve for the time interval by combining, in particular concatenating, the first RF amplitude for the first part of the time interval and the RF amplitude curve for a predefined second part of the time interval, which succeeds the first part of the time interval. The at least one computing unit 13, 14 carries out an optimization to optimize the combined RF amplitude curve using a loss function, which comprises an energy loss term, which depends on a pulse energy of the combined RF amplitude curve, and using the at least one RF curve parameter as at least one optimization variable. The at least one computing unit 13, 14 determines the asymmetric RF pulse, wherein a combined amplitude of the asymmetric RF pulse for the time interval is given by the optimized combined RF amplitude curve.

According to MR techniques, the target material is subjected to the main magnetic field, causing the nuclear spins in the target material to precess about the main magnetic field at their characteristic Larmor frequency. A net magnetic moment Mz is produced in the direction z of the main magnetic field, and the randomly oriented magnetic moments of the nuclear spins cancel out one another in the x-y-plane.

When the target material is then subjected to the transmit RF magnetic field, which is for example in the x-y plane and near the Larmor frequency, the net magnetic moment rotates out of the z-direction generating a net in-plane magnetic moment, which rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 15 of an RF controller 12 of the RF system 4, 11, 12, and processed by at least one processor 14 of the at least one computing unit 13, 14 to reconstruct an MR image using for example a computer implemented method for MR image reconstruction according to the invention.

In particular, gradient coils 3 of the MRI system 1 may produce magnetic field gradients Gx, Gy, and Gz for position-encoding of the MR signals. Accordingly, MR signals are emitted only by such nuclei of the target material, which correspond to the particular Larmor frequency. For example, Gz is used together with a bandwidth-limited RF pulse to select a slice perpendicular to the z-direction and consequently may also be denoted as slice selection gradient. In alternative example, Gx, Gy, and Gz may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by the sequence controller 13 to generate respective gradient pulses at predefined time instances.

It is noted that the components of the MRI system 1 can also be arranged differently from the arrangement shown in FIG 1. For example, the gradient coils 3 may be arranged inside the bore 5, similar as shown for the at least one RF coil 4.

A sequence controller 13 of the at least one computing unit 13, 14 may control the generation of RF pulses by an emitter channel 16 of the RF controller 12 and an RF power amplifier 11 of the RF system 4, 11, 12.

The least one processor 14 may receive the real and imaginary parts from analog-digital converters of the receiver channel 15 and reconstruct the MR image based on them according to a known technique.

It is noted that each component of the MRI system 1 may include other elements which are required for the operation thereof, and/or additional elements for providing functions other than those described in the present disclosure.

FIG 2 shows a schematic flow diagram of an exemplary implementation of a computer implemented training method for training an MLM for image enhancement for use in magnetic MR image reconstruction according to the invention.

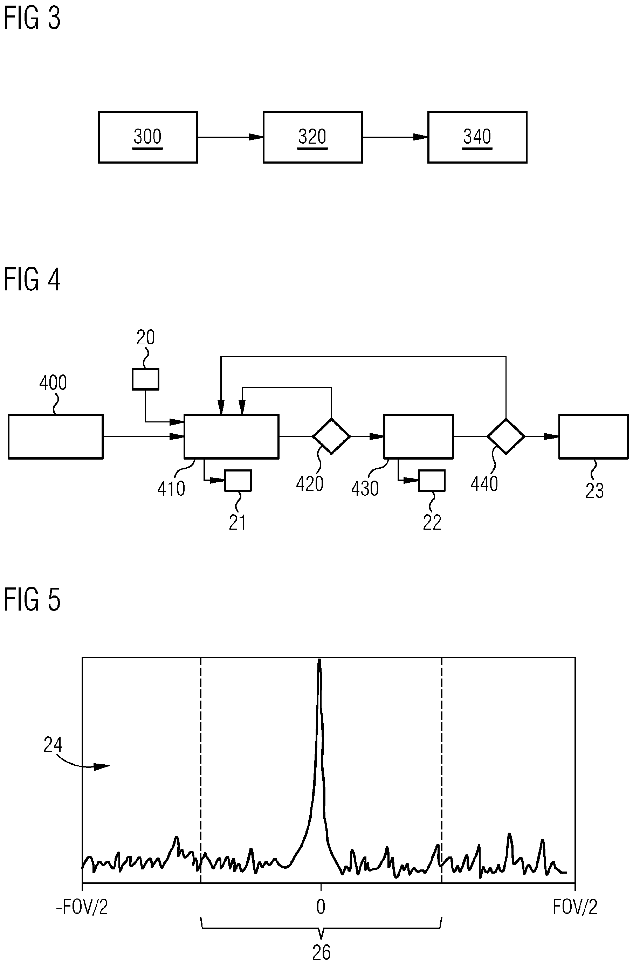

In step 200, a point spread function 24 for irregularly undersampled MR data acquisition is received. The point spread function 24 is shown schematically as a 1D-curve in FIG 5. The point spread function 24 can, however, also be a 2D-function or 3D-function in position space according to the actually used MR acquisition scheme. The point spread function 24 is defined in a field of view, FOV, and is, in particular, strongly localized in the center of the FOV.

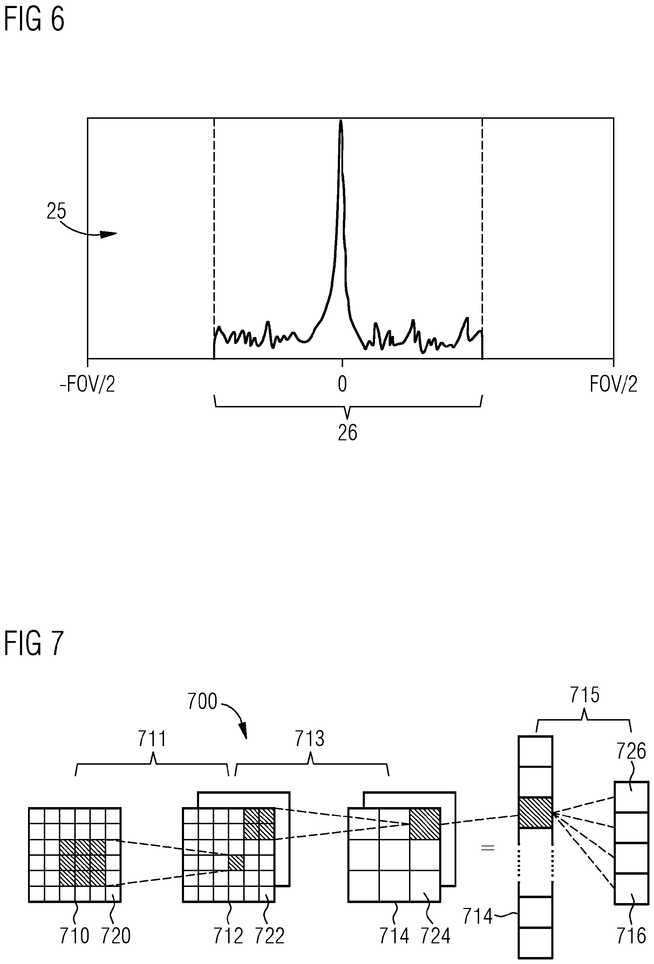

In step 220, a cropped point spread function 25 is determined, which is given by the point spread function 24 within a predefined spatial region 26, in particular around the center of the FOV, and is for example zero outside of the spatial region 26. A schematic representation of an exemplary cropped point spread function determined from the point spread function 24 given as an example in FIG 5 is shown in FIG 6. In step 240, at least one training MR dataset corresponding to at least one coil channel is received, for example from the MRI system 1, and a ground truth reconstructed MR image corresponding to the at least one training MR dataset is received. In step 260, the MLM is trained in a supervised manner depending on the at least one training MR dataset, on the ground truth reconstructed MR image, and on a Fourier transform of the cropped point spread function 25.

For example, training the MLM comprises for each iteration of at least two iterations, receiving a prior MR image for the respective iteration, generating an optimized MR image by optimizing a predefined first loss function, which depends on the at least one training MR dataset, on the prior MR image and on the Fourier transform of the cropped point spread function, and generating an enhanced MR image by applying the MLM to the optimized MR image. The prior MR image of the respective iteration is received as the enhanced MR image of a preceding iteration, unless the respective iteration corresponds to an initial iteration of the at least two iterations, and the prior MR image of the initial iteration is received as a predefined initial image. A predefined second loss function, which depends on the enhanced MR image of a final iteration of the at least two iterations and the ground truth reconstructed MR image, is evaluated, and the MLM is updated depending on a result of the evaluation of the second loss function.

FIG 3 shows a schematic flow diagram of an exemplary implementation of a computer implemented method for MR image reconstruction according to the invention.

In step 300, an MLM trained by using a computer implemented training method according to the invention is received. At least one MR image according to an undersampled MR data acquisition, the at least one MR image corresponding to at least one coil channel and representing an imaged object 6, is received, in particular from the MRI system 1. A reconstructed MR image 23 is generated depending on the at least one MR image using the trained MLM.

FIG 4 shows a schematic flow diagram of a further exemplary implementation of a computer implemented method for MR image reconstruction according to the invention, which is based on the implementation described with respect to FIG 3. Step 400 corresponds to steps 300 and 320 of FIG 3. Steps 41 to 440 are part of step 340 of FIG 3.

For each iteration of at least two iterations, a prior MR image for the respective iteration is received. The prior MR image of an initial iteration of the at least two iterations is given by a predefined initial image 20. In steps 410 and 420, an optimized MR image 21 is generated by optimizing a predefined fourth loss function, which depends on the at least one MR image, and on the prior MR image. The optimization may be carried out iteratively as well. Step 410 then corresponds to an optimization step, while in step 420, it is determined whether a termination or convergence criterion for the optimization is reached. If this is not the case, another optimization step 410 is carried out, otherwise the optimized MR image 21 is further processed in step 430.

In step 430, an enhanced MR image 22 is generated by applying the trained MLM to the optimized MR image 21. The prior MR image of the respective iteration is given by the enhanced MR image 22 of the corresponding preceding iteration, unless the respective iteration corresponds to the initial iteration. In step 440, it is determined whether a predefined total number of the at least two iterations has been carried out. If this is not the case, the next iteration is carried out. Otherwise, the reconstructed MR image 23 is determined as the enhanced MR image 22 of a final iteration of the at least two iterations.

With training hardware having noticeable limitations in available memory, common networks are often limited to perform regularization only in two directions. For three-dimensional reconstructions this is also called decoupling in the readout dimension. For time-resolved applications this also limits the range of training scenarios significantly.

According to several implementations of the invention, a training strategy is provided that allows to generate significantly smaller training samples that are on the one hand side cropped in the position space, also denoted as image domain, so that spatial and, if, applicable temporal resolution is kept, but at the same time the artifact behavior from the k-space sampling is kept. It is exploited that in the relevant use cases, the point-spread function 24 is strongly localized.

For example, k-space data for cropped patches can be synthesized for the training. As a consequence, also the efficient training of three-dimensional deep learning reconstructions that support incoherent sampling patterns as used in Compressed Sensing may be enabled. Furthermore, in several implementations, the training strategy can be applied to non-Cartesian trajectories with an additional dimension as used in GRASP or parametric mapping.

In parallel imaging, the acquired multi-coil data are related to the reconstructed images through a signal model. For Compressed Sensing and deep learning reconstructions it is convenient to use SENSE based models, as they allow to formulate a loss function and also are numerically efficient as, for example, the coil combination is performed implicitly.

A loss function relating acquired data to the combined images though pre-calculated coil-sensitivity maps is given by

$$L = \sum_{l,k} \left\| p(k)\, d_l(k) - p(k) \sum_x f_{k,x}\, C_l(x)\, M(x) \right\|^2,$$

where $l$ is the index running over the coil channels, $x$ are the indices in the image domain and $k$ are the indices in the k-space domain. $d_l(k)$ are the acquired data and, as a convention, $k$ is not limited to the set of measured data points. This is justified since the sampling pattern $p(k)$ is explicitly considered. $C_l(x)$ are the coil sensitivity maps and $M(x)$ is the reconstructed image. Finally, $f_{k,x}$ are the coefficients of the Fourier transformation. For convenience and without loss of generality, one may assume unitary conventions for the Fourier transformation and denote the coefficients of the inverse Fourier transformation with $\tilde{f}_{x,k}$. Using Parseval's theorem, one has

$$L = \sum_{l,x} \left\| \sum_k \tilde{f}_{x,k}\, p(k)\, d_l(k) - \sum_k \tilde{f}_{x,k}\, p(k) \sum_y f_{k,x}\, C_l(y)\, M(y) \right\|^2.$$

Inserting the Fourier transforms of the data corresponding to the coil images and of the sampling pattern corresponding to the point spread function 24:

$$d_l(k) = \sum_x f_{k,x}\, D_l(x),$$

$$p(k) = \sum_x f_{k,x}\, P(x),$$

which results in

$$L = \sum_{l,x} \left\| \sum_{k,y,z} \tilde{f}_{x,k}\, f_{k,y}\, P(y)\, f_{k,z}\, D_l(z) - \sum_{k,y,z} \tilde{f}_{x,k}\, f_{k,z}\, P(z)\, f_{k,y}\, C_l(y)\, M(y) \right\|^2$$

$$= \sum_{l,x} \left\| \sum_{y,z} \delta_{x,y+z}\, P(y)\, D_l(z) - \sum_{y,z} \delta_{x,y+z}\, P(z)\, C_l(y) M(y) \right\|^2$$

$$= \sum_{l,x} \left\| \sum_y P(x-y)\, D_l(y) - \sum_y P(x-y)\, C_l(y) M(y) \right\|^2.$$

As a result, both terms in the loss function relating to the acquired data and the signal model, respectively, involve a convolution with the point spread function 24. According to the invention, the point spread function 24 is cropped to the smaller region 26, that is its support is limited to a smaller matrix size.

In the image domain, the indices u, v are used in the following to index the reduced space. Assuming that the training data are fully sampled, one can generate multiple crops from each of the coil images $D_I(x)$ and the coil sensitivity maps $C_I(x)$ with the same range. Since this is an approximation, one does not necessarily have to consider wraparound behavior that naturally occurs with discrete Fourier transformations. This is also because the approximation is equally applied to both terms in the loss function and it is therefore possibly to reconstruct the desired ground truth by solving the truncated loss function for $M(x)$. So the training samples may be generated fitting to the data consistency loss function

$$\tilde{L} = \sum_{I,u} \left\| \sum_v \tilde{P}(u-v)\widetilde{D}_I(v) - \sum_v \tilde{P}(u-v)\tilde{C}_I(v)\widetilde{M}(v) \right\|^2,$$

where the ~ is generally used to indicate a cropped sample (usually multiple cropped samples can be generated from a larger sample). So one can crop the data in the image domain, keeping the resolution and the signal-to-noise ratio as in the original acquisition. This helps to achieves get a good performance of the deep learning reconstruction on realistic datasets.

It is again noted that $\tilde{P}(u)$, $\tilde{D}_I(v)$ and $\tilde{C}_I(v)$ are obtained by cropping. The points spread function 24 is cropped around the center and the other terms aligned in the larger image. $\tilde{M}(v)$ can be recalculated by assuming the ideal sampling with $\tilde{P}(u) = \delta_{0,u}$, in which case the solution is

$$\widetilde{M}(v) = \sum_I \tilde{C}_I^*(v)\,\widetilde{D}_I(v).$$

Introducing the conventions for the Fourier transformation on the smaller matrix with

$$\widetilde{d}_I(q) = \sum_u f'_{q,u}\widetilde{D}_I(u),$$

$$\tilde{p}(q) = \sum_u f'_{q,u}\tilde{P}(u),$$

wherein q indexes the k-space of the smaller matrix and $f'_{q,u}$ are the Fourier coefficients. In this notation, one recovers an optimization of very similar form

$$\tilde{L} = \sum_{I,q} \left\| \tilde{p}(q)\,\widetilde{d}_I(q) - \tilde{p}(q)\sum_u f'_{q,u}\,\widetilde{C}_I(u)\,\widetilde{M}(u) \right\|^2.$$

It is noted that in this approach $\tilde{p}(q)$ can be viewed as a down-sampling of the sampling pattern similar to image resizing. Other down-sampling methods can therefore also be used in addition.

Since deep learning reconstructions are usually using translationally invariant regularizations, the smaller samples may be used for training a given architecture. Resolution, contrast and signal-to-nose are similar to the large dataset.

According to several embodiments, a supervised training is carried out, where training pairs are generated from larger a training dataset based on the assumption of the point spread function 24 being strongly localized.

According to several embodiments, a supervised training with synthesized datasets using the cropped point spread function 25 is carried out.

The supervised training may for example be done with synthesized datasets using a resized sampling pattern. The supervised training may also be done with a reduced dataset, where the ground truth image is generated from the reduced loss function assuming full sampling, which corresponds to the assumption of a single-peak point spread function 24.

According to several embodiments, the proposed idea can be applied to three-dimensional deep learning reconstructions with a regularization being applied in all three directions.

According to several embodiments, the proposed idea can be applied to non-Cartesian acquisitions with datasets generated from Cartesian acquisitions.

According to several embodiments, the proposed idea can be applied to deep learning reconstructions that, aside from spatial dimensions, also involve additional dimensions. Examples include a time dimension for dynamic applications, a phase dimension or a contrast dimension.

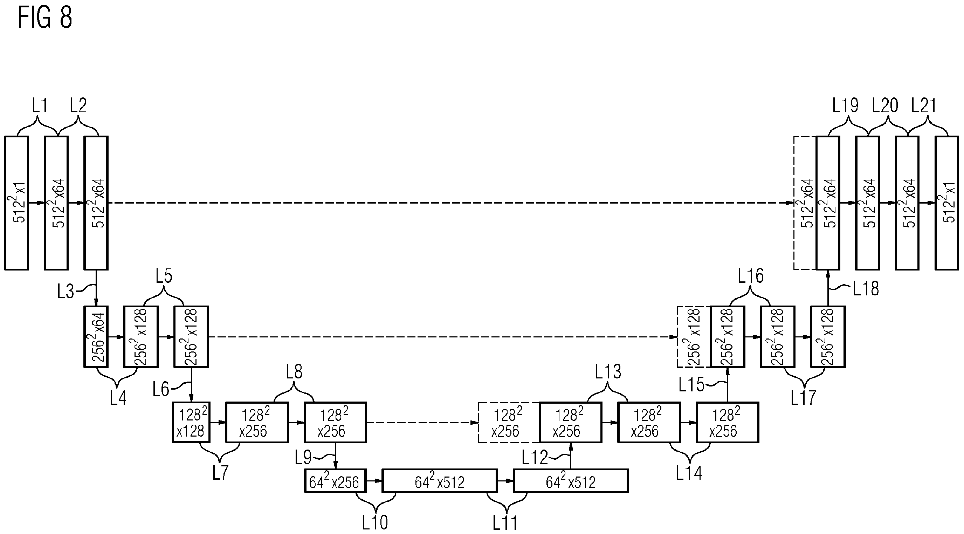

The MLM may for example be an ANN, in particular a CNN, as depicted schematically in FIG 7, FIG 8.

A CNN is an ANN that uses a convolution operation instead general matrix multiplication in at least one of its layers. These layers are denoted as convolutional layers. In particular, a convolutional layer performs a dot product of one or more convolution kernels with the convolutional layer's input data, wherein the entries of the one or more convolution kernel are parameters or weights that may be adapted by training. In particular, one can use the Frobenius inner product and the ReLU activation function. A convolutional neural network can comprise additional layers, for example pooling layers, fully connected layers, and/or normalization layers.

By using convolutional neural networks, the input can be processed in a very efficient way, because a convolution operation based on different kernels can extract various image features, so that by adapting the weights of the convolution kernel the relevant image features can be found during training. Furthermore, based on the weight-sharing in the convolutional kernels less parameters need to be trained, which prevents overfitting in the training phase and allows to have faster training or more layers in the network, improving the performance of the network.

FIG 7 displays an exemplary embodiment of a convolutional neural network 700. In the displayed embodiment, the convolutional neural network 700 comprises an input node layer 710, a convolutional layer 711, a pooling layer 713, a fully connected layer 714 and an output node layer 716, as well as hidden node layers 712, 714. Alternatively, the convolutional neural network 200 can comprise several convolutional layers 711, several pooling layers 713 and/or several fully connected layers 715, as well as other types of layers. The order of the layers can be chosen arbitrarily, usually fully connected layers 715 are used as the last layers before the output layer 716.

In particular, within a convolutional neural network 700 nodes 720, 722, 724 of a node layer 710, 712, 714 can be considered to be arranged as a d-dimensional matrix or as a d-dimensional image. In particular, in the two-dimensional case the value of the node 720, 722, 724 indexed with i and j in the n-th node layer 710, 712, 714 can be denoted as x(n)[i, j]. However, the arrangement of the nodes 720, 722, 724 of one node layer 710, 712, 714 does not have an effect on the calculations executed within the convolutional neural network 700 as such, since these are given solely by the structure and the weights of the edges.

A convolutional layer 711 is a connection layer between an anterior node layer 710 with node values x(n-1) and a posterior node layer 712 with node values x(n). In particular, a convolutional layer 711 is characterized by the structure and the weights of the incoming edges forming a convolution operation based on a certain number of kernels. In particular, the structure and the weights of the edges of the convolutional layer 711 are chosen such that the values x(n) of the nodes 722 of the posterior node layer 712 are calculated as a convolution x(n) = K * x(n-1) based on the values x(n-1) of the nodes 720 anterior node layer 710, where the convolution * is defined in the two-dimensional case as

$$x^{(n)}[i,j] = \left(K * x^{(n-1)}\right)[i,j] = \sum_{i'}\sum_{j'} K[i',j'] \cdot x^{(n-1)}[i-i', j-j'].$$

Herein, the kernel K is a d-dimensional matrix, in the present example a two-dimensional matrix, which is usually small compared to the number of nodes 720, 722, for example a 3x3 matrix, or a 5x5 matrix. In particular, this implies that the weights of the edges in the convolution layer 711 are not independent, but chosen such that they produce said convolution equation. In particular, for a kernel being a 3x3 matrix, there are only 9 independent weights, each entry of the kernel matrix corresponding to one independent weight, irrespectively of the number of nodes 720, 722 in the anterior node layer 710 and the posterior node layer 712.

In general, convolutional neural networks 700 use node layers 710, 712, 714 with a plurality of channels, in particular, due to the use of a plurality of kernels in convolutional layers 711. In those cases, the node layers can be considered as (d+1)-dimensional matrices, the first dimension indexing the channels. The action of a convolutional layer 711 is then in a two-dimensional example defined as

$$x_b^{(n)}[i,j] = \sum_a (K_{a,b} * x_a^{(n-1)}[i,j] = \sum_a\sum_{i'}\sum_{j'} K_{a,b}[i',j'] \cdot x_a^{(n-1)}[i-i', j-j'],$$

wherein $x_a^{(n)}$ corresponds to the a-th channel of the anterior node layer 710, $x_b^{(n)}$ corresponds to the b-th channel of the posterior node layer 712 and $K_{a,b}$ corresponds to one of the kernels. If a convolutional layer 711 acts on an anterior node layer 710 with A channels and outputs a posterior node layer 712 with B channels, there are A·B independent d-dimensional kernels $K_{a,b}$.

In general, in convolutional neural networks 700 activation functions may be used. In this embodiment, ReLU (rectified linear unit) is used, with R(z) = max(0, z), so that the action of the convolutional layer 711 in the two-dimensional example is

$$x_b^{(n)}[i,j] = R\left(\sum_a (K_{a,b} * x_a^{(n-1)}[i,j])\right)$$

$$= R\left(\sum_a \sum_{i'} \sum_{j'} K_{a,b}[i',j'] \cdot x_a^{(n-1)}[i-i',j-j']\right).$$

It is also possible to use other activation functions, for example ELU (exponential linear unit), LeakyReLU, Sigmoid, Tanh or Softmax.

In the displayed embodiment, the input layer 710 comprises 36 nodes 720, arranged as a two-dimensional 6x6 matrix. The first hidden node layer 712 comprises 72 nodes 722, arranged as two two-dimensional 6x6 matrices, each of the two matrices being the result of a convolution of the values of the input layer with a 3x3 kernel within the convolutional layer 711. Equivalently, the nodes 722 of the first hidden node layer 712 can be interpreted as arranged as a three-dimensional 2x6x6 matrix, wherein the first dimension correspond to the channel dimension.

An advantage of using convolutional layers 711 is that spatially local correlation of the input data can exploited by enforcing a local connectivity pattern between nodes of adjacent layers, in particular by each node being connected to only a small region of the nodes of the preceding layer.

A pooling layer 713 is a connection layer between an anterior node layer 712 with node values x(n-1) and a posterior node layer 714 with node values x(n). In particular, a pooling layer 713 can be characterized by the structure and the weights of the edges and the activation function forming a pooling operation based on a non-linear pooling function f. For example, in the two-dimensional case the values x(n) of the nodes 724 of the posterior node layer 714 can be calculated based on the values x(n-1) of the nodes 722 of the anterior node layer 712 as

$$x_b^{(n)}[i,j] = f\left(x_b^{(n-1)}[id_1, jd_2], ..., x_b^{(n-1)}[(i+1)d_1 - 1, (j+1)d_2 - 1]\right).$$

In other words, by using a pooling layer 713, the number of nodes 722, 724 can be reduced by re-placing a number $d1 \cdot d2$ of neighboring nodes 722 in the anterior node layer 712 with a single node 722 in the posterior node layer 714 being calculated as a function of the values of said number of neighboring nodes. In particular, the pooling function f can be the max-function, the average or the L2-Norm. In particular, for a pooling layer 713 the weights of the incoming edges are fixed and are not modified by training.

The advantage of using a pooling layer 713 is that the number of nodes 722, 724 and the number of parameters is reduced. This leads to the amount of computation in the network being reduced and to a control of overfitting.

In the displayed embodiment, the pooling layer 713 is a max-pooling layer, replacing four neighboring nodes with only one node, the value being the maximum of the values of the four neighboring nodes. The max-pooling is applied to each d-dimensional matrix of the previous layer. In this embodiment, the max-pooling is applied to each of the two two-dimensional matrices, reducing the number of nodes from 72 to 18.

In general, the last layers of a convolutional neural network 700 may be fully connected layers 715. A fully connected layer 715 is a connection layer between an anterior node layer 714 and a posterior node layer 716. A fully connected layer 713 can be characterized by the fact that a majority, in particular, all edges between nodes 714 of the anterior node layer 714 and the nodes 716 of the posterior node layer are present, and wherein the weight of each of these edges can be adjusted individually.

In this embodiment, the nodes 724 of the anterior node layer 714 of the fully connected layer 715 are displayed both as two-dimensional matrices, and additionally as non-related nodes, indicated as a line of nodes, wherein the number of nodes was reduced for a better presentability. This operation is also denoted as flattening. In this embodiment, the number of nodes 726 in the posterior node layer 716 of the fully connected layer 715 smaller than the number of nodes 724 in the anterior node layer 714. Alternatively, the number of nodes 726 can be equal or larger.

Furthermore, in this embodiment the Softmax activation function is used within the fully connected layer 715. By applying the Softmax function, the sum the values of all nodes 726 of the output layer 716 is 1, and all values of all nodes 726 of the output layer 716 are real numbers between 0 and 1. In particular, if using the convolutional neural network 700 for categorizing input data, the values of the output layer 716 can be interpreted as the probability of the input data falling into one of the different categories.

In particular, convolutional neural networks 700 can be trained based on the backpropagation algorithm. For preventing overfitting, methods of regularization can be used, for example dropout of nodes 720, ..., 724, stochastic pooling, use of artificial data, weight decay based on the L1 or the L2 norm, or max norm constraints.

In the example of FIG 8, the MLM is a CNN, in particular, a convolutional neural network having a U-net structure. In the displayed example, the input data to the CNN is a two-dimensional medical image comprising 512x512 pixels, every pixel comprising one intensity value. The CNN comprises convolutional layers indicated by solid, horizontal arrows, pooling layers indicating by solid arrows pointing down, and upsampling layers indicated by solid arrows pointing up. The number of the respective nodes is indicated within the boxes. Within the U-net structure first the input images are downsampled, in particular by decreasing the size of the images and increasing the number of channels. Afterwards they are upsampled, in particular by increasing the size of the images and decreasing the number of channels, to generate a transformed image.

All except the last convolutional layers L1, L2, L4, L5, L7, L8, L10, L11, L13, L14, L16, L17, L19, L20 use 3x3 kernels with a padding of 1, the ReLU activation function, and a number of filters or convolutional kernels that matches the number of channels of the respective node layers as indicated in FIG 8. The last convolutional layer uses a 1x1 kernel with no padding and the ReLU activation function.

The pooling layers L3, L6, L9 are max-pooling layers, replacing four neighboring nodes with only one node, the value being the maximum of the values of the four neighboring nodes. The upsampling layers L12, L15, L18 are transposed convolution layers with 3x3 kernels and stride 2, which effectively quadruple the number of nodes. The dashed horizontal errors correspond to concatenation operations, where the output of a convolutional layer L2, L5, L8 of the downsampling branch of the U-net structure is used as additional inputs for a convolutional layer L13, L16, L19 of the upsampling branch of the U-net structure. This additional input data is treated as additional channels in the input node layer for the convolutional layer L13, L16, L19 of the upsampling branch.

Independent of the grammatical term usage, individuals with male, female or other gender identities are included within the term.

**Claims**

1. Computer implemented training method for training a machine learning model, MLM, for image enhancement for use in magnetic resonance, MR, image reconstruction, wherein

   - a point spread function (24) for undersampled MR data acquisition is received;
   - a cropped point spread function (25) is determined, which is given by the point spread function (24) within a predefined spatial region (26);
   - at least one training MR dataset corresponding to at least one coil channel are received and a ground truth reconstructed MR image corresponding to the at least one training MR dataset is received; and
   - the MLM is trained in a supervised manner depending on the at least one training MR dataset, on the ground truth reconstructed MR image, and on a Fourier transform of the cropped point spread function (25).

2. Computer implemented training method according to claim 1, wherein training the MLM in the supervised manner comprises

   - for each iteration of at least two iterations,

     a) receiving a prior MR image for the respective iteration;
     b) generating an optimized MR image by optimizing a predefined first loss function, which depends on the at least one training MR dataset, on the prior MR image and on the Fourier transform of the cropped point spread function; and
     c) generating an enhanced MR image by applying the MLM to the optimized MR image;
     d) the prior MR image of the respective iteration is received as the enhanced MR image of a preceding iteration, unless the respective iteration corresponds to an initial iteration of the at least two iterations, and the prior MR image of the initial iteration is received as a predefined initial image;

- evaluating a predefined second loss function, which depends on the enhanced MR image of a final iteration of the at least two iterations and the ground truth reconstructed MR image; and
- updating the MLM depending on a result of the evaluation of the second loss function.

3. Computer implemented training method according to claim 2, wherein the first loss function comprises a sum over the at least one coil channel, wherein each summand of the sum comprises a term, which is given by the training MR dataset of the respective coil channel multiplied with the Fourier transform of the cropped point spread function (25).

4. Computer implemented training method according to one of claims 2 or 3, wherein the optimization of the first loss function is carried out under variation of a variable MR image, while the prior MR image is kept constant during the optimization.

5. Computer implemented training method according to claim 4, wherein the first loss function comprises a data term, which is given by

$$\sum_{I,q} \left\| \tilde{p}(q)\, \tilde{d}_I(q) - \tilde{p}(q) \sum_{v} f'_{q,v}\, \tilde{C}_I(v)\, \tilde{M}(v) \right\|^2,$$

wherein I is an index running over the at least one coil channels, q is an index running over k-space positions, v is an index running over spatial positions, $\tilde{p}$ denotes the Fourier transform of the cropped point spread function (25), $\tilde{d}_I$ denotes the training MR dataset according to the respective coil channel, $\tilde{M}$ denotes the variable MR image, $\tilde{C}_I$ denotes a predefined coil sensitivity map for the respective coil channel, and $f'_{q,v}$ denotes the Fourier coefficients of the cropped point spread function.

6. Computer implemented training method according to one of claims 4 or 5, wherein the first loss function comprises a regularization term, which depends on the prior MR image and the variable MR image.

7. Computer implemented training method according to one of the preceding claims, wherein

- at least one preliminary training image corresponding to the at least one coil channel is received; and
- at least one training MR image is generated by cropping the at least one preliminary training image, such that each of the at least one training MR image has a size, which corresponds to the spatial region (26), and the at least one training MR dataset is obtained as a Fourier transform of the least one training MR image.

8. Computer implemented training method according to one of the preceding claims, wherein the ground truth reconstructed MR image is generated by optimizing a third loss function, which depends on the at least one training MR dataset and on a Fourier transform of a full sampling point spread function.

9. Computer implemented training method according to one of the preceding claims, wherein the MLM comprises an artificial neural network.

10. Use of an MLM trained by using a computer implemented training method according to one of the preceding claims for generating a reconstructed MR image of an object (6) based on at least one MR image corresponding to at least one coil channel.

11. Computer implemented method for MR image reconstruction, wherein,

- an MLM trained by using a computer implemented training method according to one of claims 1 to 9 is received;
- at least one MR image according to an undersampled MR data acquisition, the at least one MR image corresponding to at least one coil channel and representing an imaged object (6), are received; and
- a reconstructed MR image (23) is generated depending on the at least one MR image using the MLM.

12. Computer implemented method according to claim 11, wherein

- for each iteration of at least two iterations,

a') a prior MR image for the respective iteration is received;
b') an optimized MR image (21) is generated by optimizing a predefined fourth loss function, which depends on the at least one MR image, and on the prior MR image; and
c') an enhanced MR image (22) is generated by applying the MLM to the optimized MR image (21);
d') the prior MR image of the respective iteration is received as the enhanced MR image (22) of a preceding iteration, unless the respective iteration corresponds to an initial iteration of the at least two iterations, and the prior MR image of the initial iteration is received as a predefined initial image (20);

- the reconstructed MR image (23) is determined as the enhanced MR image (22) of a final iteration of the at least two iterations.

13. Data processing apparatus comprising at least one computing unit (13, 14), which is adapted to carry out a computer implemented training method according to one of claims 1 to 9 and/or a computer implemented method according to one of claims 11 or 12.

14. System for MR imaging comprising

- a data processing apparatus according to claim 12, wherein the at least one computing unit (13, 14) is adapted carry out a computer implemented method according to one of claims 11 or 12; and
- an MRI scanner (1), wherein the at least one computing unit (13, 14) is adapted to control the MRI scanner (1) to generate the at least one MR image.

15. Computer program product comprising instructions, which, when executed by a data processing apparatus, cause the data processing apparatus to carry out a computer implemented training method according to one of claims 1 to 9 or a computer implemented method according to one of claims 11 or 12.

FIG 1

FIG 2

FIG 3

| 300 | → | 320 | → | 340 |

FIG 4

FIG 5

## FIG 6

## FIG 7

FIG 8

EP 4 585 955 A1

Europäisches
Patentamt

European
Patent Office

Office européen
des brevets

**DECLARATION**

which under Rule 63 of the European Patent Convention shall be considered, for the purposes of subsequent proceedings, as the European search report

**Application Number**

EP 24 15 1857

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|
| Reason: | INV.<br>G01R33/56 |

1.     In reply to the invitation pursuant to Rule 63(1) EPC dated 25-06-2024 and the objections under Art. 83 and 84 EPC raised therein (said objections are also reproduced in the accompanying opinion in EPO Form 1703), the applicant's arguments all hinge on the applicant's assertion that

"This step of receiving training MR data and its corresponding ground truth reconstructed MR image refers to one iteration of the training to be conducted".

However, claim 1 fails to define any iteration or iterative process, and the passages of the description cited by the applicant fail to disclose any such iteration.

More specifically, the passage on page 6, line 34 to page 7, line 10 does not refer to any specific training, let alone any training involving multiple iterations of providing a ground truth reconstructed MR image.

Additionally, the passages on page 3, lines 17-20 and lines 26-30 refer to the use of a point spread function and reduced memory requirements, but without any disclosure as to whether one or more ground truth reconstructed MR images are used for the training.

Further, the passage on page 6, lines 11-26 refers to a single ground truth reconstructed MR image without disclosing

ADD.
G01R33/561

-/--

| Place of search | Date | Examiner |
|---|---|---|
| Munich | 3 September 2024 | Raguin, Guy |

EPO FORM 1504 (P04F37)

Europäisches
Patentamt

European
Patent Office

Office européen
des brevets

**DECLARATION**

which under Rule 63 of the European Patent Convention shall be considered, for the purposes of subsequent proceedings, as the European search report

**Application Number**

EP 24 15 1857

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|

Reason:

that one is received per training iteration (or training epoch). If anything, the iterations mentioned in said passage appear to refer to those defined in present claim 2. However, claim 2 is also quite clear in that the iterations do not comprise receiving any ground truth reconstructed MR image, and actually define that, after an iterative process is carried out, a second loss function is evaluated based on the one ground truth reconstructed MR image defined in claim 1, and the MLM is updated only once based on said evaluation.

To conclude, the applicant failed to provide any supportive evidence for their assertion (using the standards established for supporting an allowable amendment of the claim under Art. 123(2) EPC), while the application actually contradicts said assertion, thereby rendering moot the applicant's arguments.

2.     As a consequence of the objections under Art. 83 and 84 EPC raised in the invitation pursuant to Rule 63(1) EPC dated 25-06-2024 and the unconvincing applicant's arguments in the letter of reply dated 26-08-2024, a meaningful search regarding the state of the art on the basis of  the entire subject-matter as claimed is not possible (Rule 63(1) EPC), whereby the emphasis is on the meaningful aspect of a potential search as per the wording of Rule 63 EPC, and no search was carried out in accordance with Rule 63(2) EPC and GL B-VIII, 3.

-/--

EPO FORM 1504 (P04F37)

| Place of search | Date | Examiner |
|---|---|---|
| Munich | 3 September 2024 | Raguin, Guy |

Europäisches
Patentamt

European
Patent Office

Office européen
des brevets

# DECLARATION

**Application Number**

which under Rule 63 of the European Patent Convention
shall be considered, for the purposes of subsequent
proceedings, as the European search report

EP 24 15 1857

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|
| Reason:<br><br>The applicant's attention is drawn to the fact that a search may be carried out during examination following a declaration of no search under Rule 63 EPC, should the problems which led to the declaration being issued be overcome (see EPC Guideline C-IV, 7.3). | |

| Place of search | Date | Examiner |
|---|---|---|
| Munich | 3 September 2024 | Raguin, Guy |

EPO FORM 1504 (P04F37)

page 3 of 3

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. ZENG et al.** A review on deep learning MRI reconstruction without fully sampled k-space. *BMC Med Imaging*, 2021, vol. 21, 195
- **O. RONNEBERGER et al.** U-Net: Convolutional Networks for Biomedical Image Segmentation. *arXiv:1505.04597v1*

- **K.P. PRUESSMANN et al.** SENSE: sensitivity encoding for fast MRI. *Magn Reson Med.*, 04 November 1999, vol. 2 (5), 952-62
- **M. UECKER et al.** ESPIRiT - an eigenvalue approach to autocalibrating parallel MRI: where SENSE meets GRAPPA.. *Magn Reson Med*, 07 March 2014, vol. 1 (3), 990-1001